# EUROPÄISCHE PATENTANMELDUNG

(11) **EP 3 886 149 A1**
(43) Veröffentlichungstag der Anmeldung: **29.09.2021**
(21) Anmeldenummer: 21173599.8
(22) Anmeldetag: 22.08.2011
(51) Int. Cl.: H01L 21/683, H01L 21/67

(54) **VORRICHTUNG UND VERFAHREN ZUM BONDEN VON SUBSTRATEN**

(30) Priorität: 12.08.2011 WO PCT/EP2011/063968
(62) Teilanmeldung aus: 11763609.2
(71) Anmelder: EV Group E. Thallner GmbH, 4782 St. Florian am Inn (AT)
(72) Erfinder: Wagenleitner, Thomas, 4782 St. Florian am Inn (AT)
(74) Vertreter: Schneider, Sascha

(57) **Zusammenfassung**

Die vorliegende Erfindung betrifft eine Vorrichtung zum Bonden eines ersten Substrats (15) mit einem zweiten Substrat mit folgenden Merkmalen:
- einer Aufnahmeeinrichtung zur Aufnahme des ersten Substrats (15) an einer Aufnahmekontur (8, 8', 8", 8"', 8^{IV}) mit einer wirksamen Aufnahmefläche (7, 7', 7", 7"', 7^{IV}) der Aufnahmeeinrichtung mit einem äußeren Ringabschnitt (10) zur steuerbaren Fixierung des ersten Substrats (15),
- Verformungsmitteln zur steuerbaren Verformung des ersten Substrats (15), wobei die Verformungsmittel innerhalb des äußeren Ringabschnitts wirkend ausgebildet sind und
- Bondmitteln zum Bonden des ersten Substrats (15) mit dem zweiten Substrat ().

Weiterhin betrifft die Erfindung ein Verfahren zum Bonden eines ersten Substrats (15) mit einem zweiten Substrat mit folgenden Schritten, insbesondere folgendem Ablauf:
- Aufnahme des ersten Substrats (15) an einer Aufnahmekontur (8, 8', 8", 8"') mit einer wirksamen Aufnahmefläche (7, 7', 7", 7"', 7^{IV}) der Aufnahmeeinrichtung (1) mit einem äußeren Ringabschnitt (10) zur steuerbaren Fixierung des ersten Substrats (15),
- Verformung des ersten Substrats (15) innerhalb des äußeren Ringabschnitts durch Verformungsmitteln zur steuerbaren Verformung des ersten Substrats (15)
- Bonden des ersten Substrats (15) mit dem zweiten Substrat durch Bondmittel.

## Beschreibung

Die vorliegende Erfindung betrifft eine Vorrichtung zum, insbesondere temporären, Bonden, insbesondere Pre-Bonden eines ersten Substrats mit einem zweiten Substrat gemäß den nebengeordneten Ansprüchen.

In der Halbleiterindustrie werden Aufnahmeeinrichtungen beziehungsweise Probenhalter (sogenannte Chucks) als Handhabungseinrichtung zur Stützung und Fixierung von flächigen Halbleitersubstraten, insbesondere Wafern, verwendet. Die Wafer liegen dabei plan auf, werden hierdurch gestützt, fixiert und können somit zu verschiedenen Verarbeitungsschritten und Bearbeitungsstationen transportiert werden.

Dabei ist es teilweise notwendig, den Wafer von einer Aufnahmeeinrichtung zur anderen zu übergeben, so dass nicht nur die zuverlässige und ebene Stützung/Fixierung, sondern auch ein möglichst schonendes und einfaches Ablösen des Wafers eine große Rolle spielt.

Die Fixierung erfolgt beispielsweise durch Anlegen eines Vakuums zwischen dem Wafer und der Aufnahmeeinrichtung, durch elektrostatische Aufladung, oder durch andere steuerbare chemisch-physikalische Adhäsionseigenschaften wobei das Ablösen des Wafers auf Grund der immer dünneren, und manchmal sogar doppelseitig polierten, Wafer und gegebenenfalls vorhandenen Eigenadhäsion des Wafers an dem Probenhalter technisch immer schwieriger wird. Die Flächen, an denen die Fixierung erfolgt, können auch mit einem Muster versehen sein, einer Rillung oder einer anderen beliebigen Topographie, welche die Kontaktfläche weiter reduziert um eine möglichst geringe Aufnahmefläche zu erhalten.

Einen wichtigen Aspekt stellt auch die Vermeidung von Kontaminationen dar.

Eine wichtige Rolle spielen diese bei Verfahren und Vorrichtungen zum Bonden zweier Substrate (Wafer), insbesondere bei dem kritischen Schritt der Kontaktierung der ausgerichteten Kontaktflächen der beiden gegenüberliegenden Substrate, denn die Forderung geht hin zu immer exakterer Justiergenauigkeit beziehungsweise Offset von weniger als 2µm, insbesondere weniger als 250nm, vorzugsweise weniger als 150nm, am bevorzugtesten weniger als 50nm. Bei solchen Ausrichtungsgenauigkeiten sind viele Einflussfaktoren zu berücksichtigen. Besonders kritisch ist aber das Ablegen/Kontaktieren der Substrate, da hierbei Fehler auftreten können, wobei sich die Fehler addieren können und somit eine reproduzierbare Justiergenauigkeit nicht eingehalten werden kann. Dies führt zu erheblichem Ausschuss.

Aufgabe der vorliegenden Erfindung ist es daher, eine Vorrichtung und ein Verfahren zum Bonden zweier Substrate, vor allem zum Pre-Bonden oder Temporärbonden, vorzusehen, mit dem eine möglichst gute Justiergenauigkeit an allen Stellen des Wafers erreicht wird, wobei nach Möglichkeit auch Kontaminationen des Substrats vermieden werden.

Im weiteren Verlauf sollen die Worte Bonden, Temporärbonden und Prebonden synonym verwendet werden. Einem Fachmann auf dem Gebiet ist klar, dass die Erfindung vorzugsweise aber nicht einschränkend entwickelt wurde, um zwei Wafer durch einen Prebond, möglichst vollflächig verzerrungs- und dehnungsfrei miteinander zu verbinden.

Für das Pre-Bonden zur Erzeugung eines vorläufigen oder reversiblen Bonds zwischen den Substraten existieren bereits mehrere Verfahren, die dem Fachmann auf dem Gebiet bekannt sind. Die Prebondstärken liegen dabei unter den Permanentbondstärken, zumindest um den Faktor 2 bis 3, insbesondere um den Faktor 5, vorzugsweise um den Faktor 15, noch bevorzugter um den Faktor 25.Als Richtgrößen werden die Pre-Bondstärken von reinem, nicht aktiviertem, hydrophilisierten Silizium mit ca. 100mJ/m² und von reinem, plasmaaktivierten hydrophiliserten Silizium mit ca. 200-300mJ/m² erwähnt. Die Prebonds zwischen den mit Molekülen benetzten Substraten kommen hauptsächlich durch die van-der-Waals Wechselwirkungen zwischen den Molekülen der unterschiedlichen Waferseiten zustande.

Zum Bonden sind erfindungsgemäß Bondmittel zum Bonden und/oder Prebonden und/oder temporären Bonden vorgesehen.

Die vorliegende Aufgabe wird mit den Merkmalen der unabhängigen Patentansprüche gelöst. Vorteilhafte Weiterbildungen der Erfindung sind in den Unteransprüchen angegeben. In den Rahmen der Erfindung fallen auch sämtliche Kombinationen aus zumindest zwei in der Beschreibung, in den Ansprüchen und/oder den Zeichnungen angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Erfindungsgemäß vorgesehen ist eine Vorrichtung zum, insbesondere temporären, Bonden eines ersten Substrats mit einem zweiten Substrat mit folgenden Merkmalen:
- einer Aufnahmeeinrichtung zur Aufnahme des ersten Substrats an einer Aufnahmekontur mit einer wirksamen Aufnahmefläche der Aufnahmeeinrichtung mit einem äußeren Ringabschnitt zur steuerbaren Fixierung des ersten Substrats,
- Verformungsmitteln zur steuerbaren Verformung des ersten Substrats, wobei die Verformungsmittel innerhalb des äußeren Ringabschnitts wirkend ausgebildet sind und
- Bondmitteln zum Bonden des ersten Substrats mit dem zweiten Substrat.

Erfindungsgemäß vorgesehen ist weiterhin ein Verfahren zum, insbesondere temporären, Bonden eines ersten Substrats mit einem zweiten Substrat mit folgenden Schritten, insbesondere folgendem Ablauf:
- Aufnahme des ersten Substrats an einer Aufnahmekontur mit einer wirksamen Aufnahmefläche der Aufnahmeeinrichtung mit einem äußeren Ringabschnitt zur steuerbaren Fixierung des ersten Substrats,
- Verformung des ersten Substrats innerhalb des äußeren Ringabschnitts durch Verformungsmitteln zur steuerbaren Verformung des ersten Substrats,
- Bonden des ersten Substrats mit dem zweiten Substrat durch Bondmittel.

Der Erfindung liegt der Gedanke zugrunde, die beiden Substrate möglichst koordiniert und gleichzeitig quasi-selbsttätig zu kontaktieren, indem zumindest eines der Substrate mit einer, insbesondere konzentrisch zur Mitte M einer Kontaktfläche des Substrats radial nach außen verlaufenden, Vorspannung vor dem Kontaktieren beaufschlagt wird und dann nur der Beginn des Kontaktierens beeinflusst wird, während nach Kontaktierung eines Abschnitts, insbesondere der Mitte M des Substrats, das Substrat freigelassen wird und selbsttätig auf Grund seiner Vorspannung kontrolliert mit dem gegenüberliegenden Substrat bondet. Die Vorspannung wird durch eine Verformung des ersten Substrats mittels Verformungsmitteln erreicht, wobei die Verformungsmittel insbesondere auf Grund ihrer Form auf die zur Bondseite abgewandten Seite einwirken und die Verformung entsprechend durch Einsatz unterschiedlicher (insbesondere austauschbarer) Verfomungsmittel steuerbar ist. Die Steuerung erfolgt auch durch den Druck oder die Kraft, mit der Die Verformungsmittel auf das Substrat wirken. Vorteilhaft ist es dabei, die wirksame Aufnahmefläche der Aufnahmeeinrichtung mit dem Halbleitersubstrat zu reduzieren, so dass das Halbleitersubstrat nur teilweise von der Aufnahmeeinrichtung gestützt wird. Auf diese Weise ergibt sich durch die kleinere Kontaktfläche eine geringere Adhäsion zwischen dem Wafer und dem Probenhalter beziehungsweise der Aufnahmeeinrichtung. Eine Fixierung wird erfindungsgemäß, insbesondere ausschließlich, im Bereich des Umfangs des Halbleitersubstrats (erstes Substrat) angelegt, so dass eine effektive Fixierung gegeben ist bei gleichzeitig geringst möglicher wirksamer Aufnahmefläche zwischen der Aufnahmekontur der Aufnahmeeinrichtung und dem Halbleitersubstrat. Somit ist gleichzeitig ein schonendes und sicheres Ablösen des Halbleitersubstrats möglich, da die zum Ablösen des Wafers notwendigen Lösekräfte so gering wie möglich sind.

Die Aufnahmekontur ist der Bereich der Aufnahmeeinrichtung, auf dem das Halbleitersubstrat zum Liegen kommt, so dass der Außenumfang bei kreisförmigen Halbleitersubstraten entsprechend kreisförmig mit analogen Abmessungen ist. Übliche Außenabmessungen sind Durchmesser von 200mm, 300mm oder 450mm.

Gleichzeitig sind in dem Bereich der Aufnahmekontur außerhalb der wirksamen Aufnahmefläche erhabene Strukturen des Wafers aufnehmbar, so dass die Aufnahmeeinrichtung gleichzeitig CMOS-kompatibel ausgebildet ist.

Das Ablösen ist vor allem kontrollierbar, insbesondere durch Reduzierung des Unterdrucks an der Aufnahmefläche. Kontrollierbar bedeutet, dass nach dem Kontakt des Wafers mit einem zweiten Wafer, der Wafer am Probenhalter noch fixiert bleibt und erst durch gezielte (gesteuerte) Reduzierung des Unterdrucks ein Loslösen des Substrats (Wafers) vom Probenhalter (Aufnahmeeinrichtung), insbesondere von innen nach außen, bewirkt wird. Die erfindungsgemäße Ausführungsform führt vor allem dazu, dass das Ablösen durch sehr geringe Kräfte bewerkstelligt werden kann.

Die Substrate (Wafer) werden vor dem Bondvorgang zueinander ausgerichtet, um Deckungsgleichheit (exakte Ausrichtung, insbesondere mit einer Genauigkeit von weniger als 2µm, vorzugsweise weniger als 250nm, noch bevorzugter weniger als 150nm, am bevorzugtesten weniger als 100nm) korrespondierender Strukturen auf deren Oberflächen zu gewährleisten. Bei dem erfindungsgemäßen Bondverfahren werden die Wafer nicht plan aufeinander gelegt, sondern zunächst in der Mitte M miteinander in Kontakt gebracht, indem einer der beiden Wafer leicht gegen den zweiten Wafer gedrückt wird beziehungsweise entsprechend in Richtung des gegenüberliegenden Wafers verformt wird. Nach dem Loslösen des verformten (in Richtung des gegenüberliegenden Wafers) durchgebogenen Wafers erfolgt durch das Voranschreiten einer Bondwelle ein kontinuierliches und gleichmäßigeres, mit minimalster Kraft und damit mit minimalsten, vorwiegend horizontalen, Verzerrungen verbundenes, insbesondere zumindest überwiegend selbsttätiges, Verschweißen entlang der Bondfront.

Gemäß einer vorteilhaften Ausführungsform der Erfindung ist vorgesehen, dass die Aufnahmekontur und/oder die Aufnahmefläche und/oder die Aufnahmeeinrichtung rotationssymmetrisch, insbesondere konzentrisch zu einem Zentrum Z der Aufnahmeeinrichtung, ausgebildet ist/sind. Hierdurch wird eine gleichmäßige Halterung und einfache Fertigung der Aufnahmeeinrichtung erreicht. Soweit die Aufnahmeeinrichtung zumindest an der Aufnahmefläche starr ausgebildet ist, ist eine sichere und ausrichtungsgenaue Fixierung des Wafers möglich.

Indem mindestens ein die Aufnahmefläche unterbrechender Unterdruckkanal in dem äußeren Ringabschnitt der Aufnahmekontur vorgesehen ist und die Aufnahmekontur in einem inneren Ringabschnitt zumindest überwiegend gegenüber der Aufnahmefläche zurückgesetzt ist, ist eine für die Durchführung der vorliegenden Erfindung vorteilhafte geometrische Anordnung gegeben, mit der einerseits die Verformung perfekt umgesetzt und andererseits die Kontaktierung auf die oben beschriebene Weise kontrolliert und mit geringem Aufwand durchgeführt werden kann.

Mit Vorteil verläuft der Unterdruckkanal konzentrisch, insbesondere kreisringförmig, zu einem Zentrum Z der Aufnahmeeinrichtung, insbesondere vollumfänglich. Hierdurch wird eine gleichmäßige Fixierung gewährleistet.

In einer weiteren, vorteilhaften Ausführungsform der Erfindung ist vorgesehen, dass die Ringbreite b_{A} des äußeren, insbesondere kreisringförmigen, Ringabschnitts kleiner als die Ringbreite b_{I} des inneren Ringabschnitts ist. Das Verhältnis der Ringbreite b_{A} zu b_{I} ist insbesondere kleiner 1 zu 3, vorzugsweise kleiner 1 zu 5, noch bevorzugter kleiner 1 zu 7. Je kleiner die Ringbreite b_{A} im Verhältnis zur Ringbreite b_{I} ist, desto leichter lässt sich das Halbleitersubstrat von der Aufnahmeeinrichtung ablösen.

Dabei ist es von besonderem Vorteil, wenn die Projektionsfläche der Aufnahmekontur mindestens doppelt, insbesondere dreimal, so groß wie die wirksame Aufnahmefläche ist.

Gemäß einer weiteren, vorteilhaften Ausführungsform der Erfindung ist vorgesehen, dass die Aufnahmekontur im inneren Ringabschnitt mindestens eine, insbesondere kreisringförmige, vorzugsweise konzentrisch zum Zentrum Z angeordnete, Auflagefläche zur Auflage, insbesondere ohne aktive Fixierung, des Halbleitersubstrats aufweist, wobei die Auflagefläche zur Aufnahmefläche zählt und mit dieser fluchtet. Durch diese Maßnahme wird eine weitere Planarisierung der Aufnahmeeinrichtung bei der Handhabung erreicht, so dass sich das Halbleitersubstrat nicht zur Aufnahmeeinrichtung hin durchbiegt oder generell wölbt.

In einer weiteren, erfindungsgemäßen Ausführungsform ist vorgesehen, dass die Verformungsmittel eine Beaufschlagung des Halbleitersubstrats auf der Seite der Aufnahmefläche, insbesondere außerhalb, vorzugsweise ausschließlich außerhalb, der Aufnahmefläche, bewirkend ausgebildet sind. Es hat sich überraschend gezeigt, dass durch Beaufschlagung des Halbleitersubstrats an der Seite der Aufnahmefläche (meist Rückseite des Halbleitersubstrats) ein besonders schonendes Ablösen möglich ist.

Außerdem wird eine Kontamination der anderen (meist wichtigeren, weil diese beispielsweise bearbeitet sind) Flächen des Halbleitersubstrats vermieden.

Soweit als Verformungsmittel mindestens ein die Aufnahmekontur durchsetzendes Druckelement vorgesehen ist, kann der Druck gleichmäßig, insbesondere vom Zentrum Z aus, aufgebracht werden. Hierbei ist eine mechanische Lösung, insbesondere durch einen Stift, aber auch Beaufschlagung mit einem Fluid, insbesondere einem Gas, möglich. Hierzu ist insbesondere eine den Aufnahmekörper durchsetzende Öffnung, insbesondere Bohrung, vorgesehen.

Besonders effektiv und mit einer hohen Justiergenauigkeit auf Grund geringstmöglicher Verzerrung erfolgt das Bonden, wenn die Verformungsmittel derart ausgebildet sind, dass die Verformung konzentrisch zum ersten Substrat erfolgt.

Gemäß einer weiteren, vorteilhaften Ausführungsform ist vorgesehen, dass im inneren Ringabschnitt, insbesondere einzeln ansteuerbare, Fixierelemente zur Fixierung von korrespondierenden Fixierabschnitten entlang des ersten Substrats vorgesehen sind. Hierdurch kann zusätzlich auf Verzerrungen und/oder Dehnungen in der x-,y- und/oder z-Richtung des ersten und/oder zweiten Substrats Einfluss genommen werden. Die (überwiegend entlang der Kontaktfläche der Substrate, also in der Fläche verlaufenden) Verzerrungen und/oder Dehnungen werden insbesondere in einem vorherigen Verfahrensschritt, vorzugsweise in Form von Spannungs- und/oder Dehnungskarten des Substrats/der Substrate aufgenommen und durch Schaltung der Fixierelements wird beim Kontaktieren der Substrate eine abschnittsweise zusätzliche Verformung erzeugt, die so ausgebildet ist, dass, insbesondere lokale, Verzerrungen/Dehnungen ausgeglichen werden. Denn durch solche Verzerrungen/Dehnungen wird die Ausrichtungsgenauigkeit, insbesondere bei Ausrichtungsgenauigkeiten unter 250nm, immer stärker beeinflusst. Es kann also grundsätzlich zwischen horizontalen und vertikalen Verzerrungen unterschieden werden. Die vertikalen Verzerrungen entstehen durch den Evakuierungsprozess in vertikaler Richtung, also in z-Richtung. Diese Verzerrungen haben aber notwendigerweise auch die horizontalen, also die x- und y-Verzerrungen zur Folge, welche in Hinblick auf die zu erreichende Ausrichtungsgenauigkeit das eigentliche Problem darstellen.

Verfahrensgemäß wird dies gelöst, indem, insbesondere durch ein vorgeschaltetes Messverfahren ermittelte, Verzerrungen und/oder Dehnungen des ersten und/oder zweiten Substrats durch Einwirkung, insbesondere durch gesteuerte Verzerrung und/oder Dehnung von Abschnitten des ersten und/oder zweiten Substrats, auf das erste und/oder zweite Substrat reduziert werden, insbesondere mittels Fixierelementen zur Fixierung von korrespondierenden Fixierabschnitten. Die Ermittlung der Verzerrungen und/oder Dehnungen kann durch ein externes Messgerät erfolgen. Das externe Messgerät ist dann entsprechend mit der erfindungsgemäßen Ausführungsform über einer Datenverbindung verbunden. Mit Vorzug würde sich ein Messgerät zur Ermittlung der Verzerrungs- und/oder Dehnungskarten im gleichen Modul wie die erfindungsgemäße Ausführungsform befinden. Des Weiteren soll die Möglichkeit offenbart sein, für die Ansteuerung des Gerätes zur Ermittlung der Verzerrungs- und/oder Dehnungskarten, sowie der erfindungsgemäßen Ausführungsform das gleiche Interface zu verwenden. Unter einem Interface verstehen wir jede Art von Gerät der Steuerungskontrolle. Mit Vorzug handelt es sich dabei um einen Computer mit entsprechender Steuerungssoftware und einer entsprechenden graphischen Benutzeroberfläche.

Vorrichtungsgemäß offenbarte Merkmale sollen auch als verfahrensgemäß offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1a: eine Aufsicht auf eine Aufnahmekontur einer ersten Ausführungsform einer erfindungsgemäßen Vorrichtung mit einer Schnittlinie A-A,
- Figur 1b: eine Ansicht gemäß Schnittlinie A-A aus Figur 1a,
- Figur 2a: eine Aufsicht auf eine Aufnahmekontur einer zweiten Ausführungsform der erfindungsgemäßen Vorrichtung mit einer Schnittlinie B-B,
- Figur 2b: eine Ansicht gemäß Schnittlinie B-B aus Figur 2a,
- Figur 3a: eine Aufsicht auf eine Aufnahmekontur einer dritten Ausführungsform der erfindungsgemäßen Vorrichtung mit einer Schnittlinie C-C,
- Figur 3b: eine Ansicht gemäß Schnittlinie C-C aus Figur 3a,
- Figur 4a: eine Aufsicht auf eine Aufnahmekontur einer vierten Ausführungsform der erfindungsgemäßen Vorrichtung mit einer Schnittlinie D-D,
- Figur 4b: eine Ansicht gemäß Schnittlinie D-D aus Figur 4a,
- Figur 5a: eine Querschnittsansicht der ersten Ausführungsform gemäß Figur 1a kurz vor dem Ablösen,
- Figur 5b: eine Querschnittsansicht gemäß Figur 5a beim Ablösen des Halbleitersubstrats und
- Figur 6: eine schematische Darstellung verschiedener Formen eines Stifts zum Ablösen des Halbleitersubstrats.
- Figur 7a: eine schematische Aufsicht auf eine fünfte Ausführungsform der erfindungsgemäßen Vorrichtung und
- Figur 7b: eine Querschnittsansicht der Ausführungsform gemäß Figur 7a.
- Figur 8a: eine Querschnittsansicht zweier miteinander zu verschweißender Wafer vor der Kontaktierung durch einen Stift
- Figur 8b: eine Querschnittsansicht zweier miteinander zu verschweißender Wafer während der Kontaktierung des oberen Wafers durch einen Stift
- Figur 8c: eine Querschnittsansicht zweier miteinander zu verschweißender Wafer während der elastischen Durchbiegung des oberen Wafers durch einen Stift
- Figur 8d: eine Querschnittsansicht zweier miteinander zu verschweißender Wafer während des ersten Kontaktes zwischen dem oberen und unteren Wafers
- Figur 8e: eine Querschnittsansicht zweier miteinander zu verschweißender Wafer während der fortlaufenden Bondwelle zwischen dem oberen und unterem Wafer
- Figur 8f: eine Querschnittsansicht zweier miteinander zu verschweißender Wafer, in welcher der obere Wafer bereits vom Probenhalter abgelöst wurde
- Figur 8g: eine Querschnittsansicht zweier miteinander zu verschweißender Wafer, im gebondeten Zustand

In den Figuren sind gleiche Bauteile und Bauteile mit der gleichen Funktion mit den gleichen Bezugszeichen gekennzeichnet.

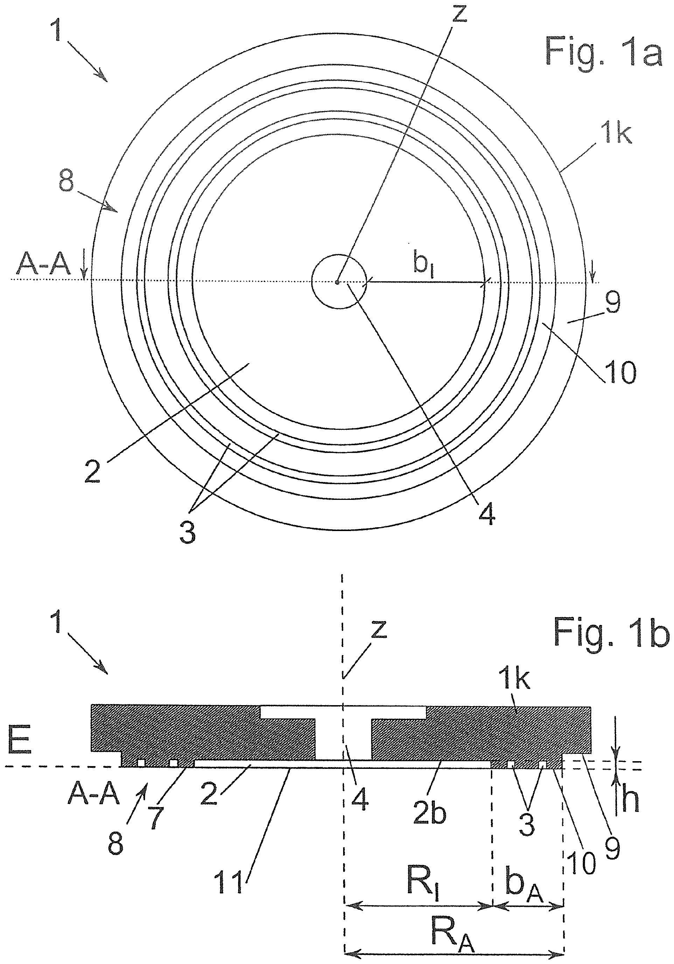

Figur 1a zeigt eine Aufnahmeeinrichtung 1 (in der Halbleiterindustrie auch als Chuck bezeichnet) einer Vorrichtung zur Aufnahme eines ersten Halbleitersubstrats 15 (Wafer) auf einer Aufnahmekontur 8 der Aufnahmeeinrichtung 1. Die Aufnahmekontur 8 weist eine Struktur auf, die in einer Aufnahmeebene E eine Aufnahmefläche 7 aufweist. Nur die Aufnahmefläche 7 tritt in Kontakt mit dem Halbleitersubstrat 15 (bei Aufnahme des Halbleitersubstrats 15 auf die Aufnahmeeinrichtung 1 (wirksame Aufnahmefläche).

Die Aufnahmeeinrichtung 1 ist aus einem, insbesondere monolithischen und/oder metallischen und/oder starren, Aufnahmekörper 1k gebildet, was in der Querschnittsansicht gemäß Figur 1b besonders gut zu erkennen ist. Eine Beschichtung des Aufnahmekörpers zur Vermeidung von Kratzern oder Metallionenkonzentrationen ist möglich. Von den Abmessungen her ist zumindest die Aufnahmekontur 8 der Aufnahmeeinrichtung 1 an die Abmessungen der aufzunehmenden Halbleitersubstrate 15 angepasst, so dass ein äußerer Ringradius R_{A} der Aufnahmekontur 8 im Wesentlichen dem Radius der aufzunehmenden Halbleitersubstrate 15 entspricht. Die Durchmesser der Halbleitersubstrate entsprechen mit Vorzug den in der Industrie üblichen, standardisierten Durchmessern von 2", 4", 6", 8", 12" beziehungsweise 18" etc., können aber auch von diesen abweichen, sofern dies nötig wird. Die Formen der Aufnahmekontur 8 und der Aufnahmeeinrichtung 1 sind in einer Aufsicht kreisringförmig, entsprechend der üblichen Form der Halbleitersubstrate 15. Der Radius Rₖ des Aufnahmekörpers 1k kann wegen der einfacheren Handhabung größer sein als der äußere Ringradius R_{A} der Aufnahmekontur 8. Am Umfang des Aufnahmekörpers 1k bis zum Umfang der Aufnahmekontur 8 kann ein gegenüber der Aufnahmeebene E zurückgesetzter Absatz 9 vorgesehen sein, um die Handhabung der Aufnahmeeinrichtung 1 zu erleichtern (insbesondere bei der Beladung des Halbleitersubstrats 15). Der Umfang des Aufnahmekörpers 1k und der Umfang der Aufnahmekontur 8 sind konzentrisch zu einem Zentrum Z der Aufnahmeeinrichtung 1 beziehungsweise der Aufnahmekontur 8.

Von dem Umfang der Aufnahmekontur 8 (also von dem äußeren Ringradius R_{A}) erstreckt sich ein äußerer Ringabschnitt 10 der Aufnahmekontur 8 bis zu einem inneren Ringradius R_{I}. Der äußere Ringabschnitt 10 ist zur Fixierung des flächigen Halbleitersubstrats 15 mittels Unterdruck vorgesehen. Der Unterdruck wird an zwei zueinander konzentrisch verlaufenden Unterdruckkanälen 3 durch eine nicht dargestellte Vakuumeinrichtung angelegt. Die Unterdruckkanäle 3 verlaufen zwischen dem äußeren Ringradius R_{A} und dem inneren Ringradius R_{I}, also vollständig in dem Ringabschnitt 10. Die Unterdruckkanäle 3 unterbrechen die wirksame Aufnahmefläche 7 und durch den Unterdruck an den Unterdruckkanälen 3 wird das Halbleitersubstrat 15 an der Aufnahmefläche 7 im Bereich des äußeren Ringabschnitts 10 fixiert (Fixierung des ersten Substrats 15). Der Unterdruck, und damit die effektiv wirksame Fixierkraft, kann mit Vorzug gesteuert eingestellt werden (über eine entsprechende Steuerungseinrichtung zur Steuerung der Vorrichtung). Des Weiteren kann der Probenhalter (Aufnahmeeinrichtung 1) mit Vorzug so gefertigt sein, dass eine verschließbare Dichtung, den Probenhalter versiegelt und den Unterdruck ohne kontinuierliches Absaugen von Außen aufrechterhält. Dadurch kann der Probenhalter von jeder Maschine entfernt werden, wobei die Fixierung des ersten Substrats 15 zumindest über einen bestimmten Zeitraum aufrechterhalten bleibt.

Im Ausführungsbeispiel gemäß den Figuren 1a und 1b entspricht die Aufnahmefläche 7 der Oberfläche des äußeren Ringabschnitts 10 in der Aufnahmeebene E. Innerhalb des äußeren Ringabschnitts 10 (also in einem inneren Ringabschnitt 11) ist die Aufnahmekontur 8 gegenüber der Aufnahmefläche 7 zurückgesetzt und bildet eine kreisringförmige Vertiefung 2, deren Radius dem inneren Ringradius R_{I} entspricht. Somit ist die Vertiefung 2 konzentrisch zu dem Umfang der Aufnahmekontur 8 beziehungsweise konzentrisch zum äußeren Ringabschnitt 10. Ein Boden 2b der Vertiefung 2 verläuft parallel zur Aufnahmeebene E mit einem Abstand, der der Höhe h der Vertiefung 2 entspricht. Die Höhe h der Vertiefung 2 kann in vorteilhafter Ausführung der Tiefe der Unterdruckkanäle 3 entsprechen (einfachere Fertigung).

Damit sich in der Vertiefung 2 bei der Aufnahme des Halbleitersubstrats 15 kein Unterdruck bildet, ist eine den Aufnahmekörper 1k durchsetzende Öffnung 4 vorgesehen. Die Öffnung 4 kann als Bohrung, insbesondere konzentrisch zum Zentrum Z beziehungsweise zum Umfang der Aufnahmekontur 8, vorgesehen sein.

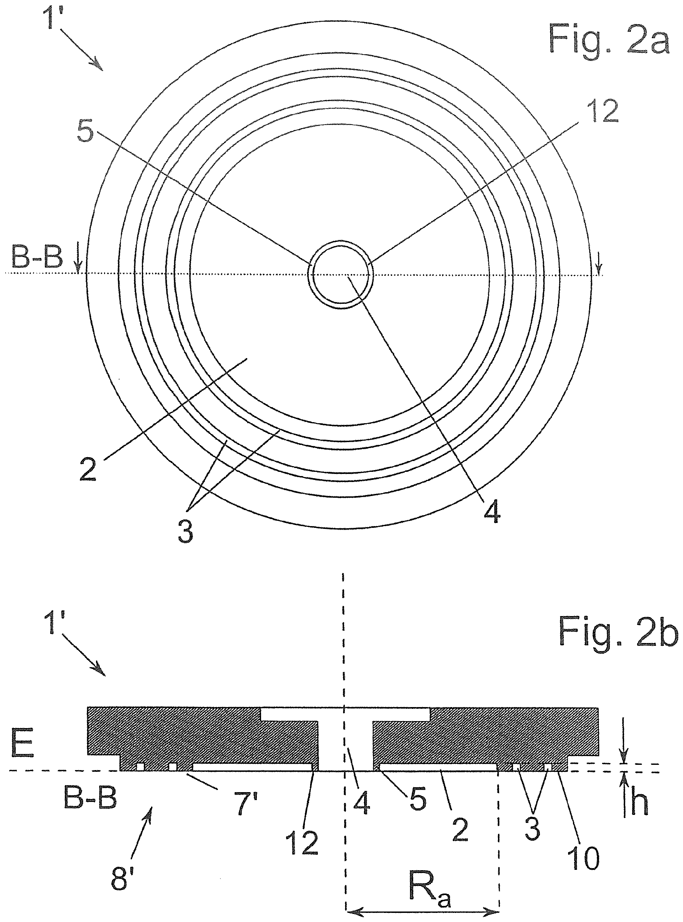

In der zweiten Ausführungsform gemäß Figuren 2a und 2b besteht die Aufnahmefläche 7' nicht nur aus dem äußeren Ringabschnitt 10. Vielmehr weist die Aufnahmekontur 8 (beziehungsweise der Aufnahmekörper 1k) eine kreisringförmige, konzentrisch zum Zentrum Z angeordnete Auflagefläche 12 auf, die durch einen unmittelbar an der Öffnung 4 vorgesehenen Vorsprung 5 gebildet wird.

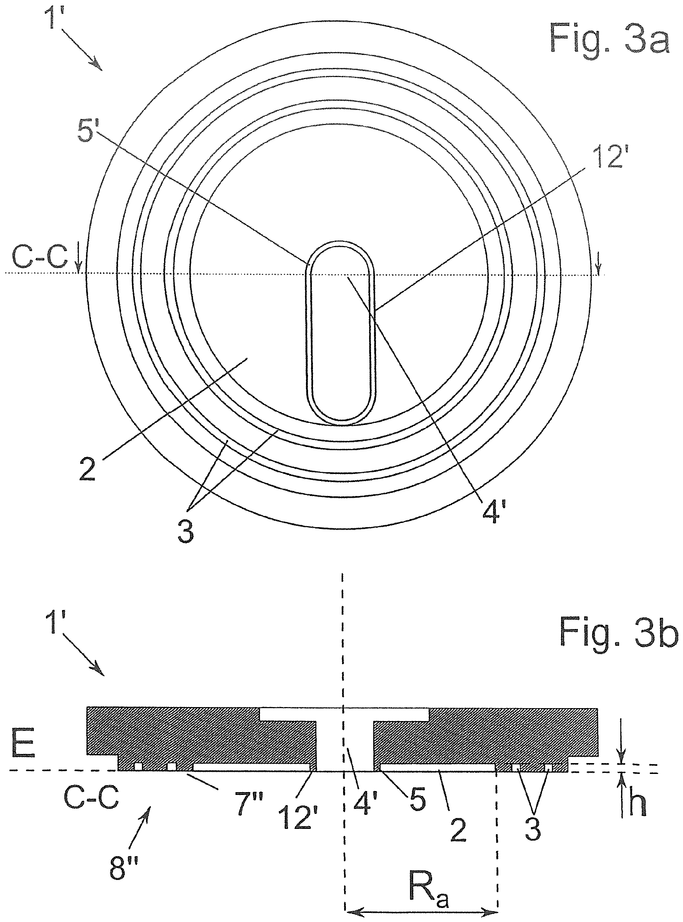

In der dritten Ausführungsform gemäß Figuren 3a und 3b ist die Öffnung 4' nicht mehr kreisförmig und konzentrisch zum Zentrum Z ausgebildet, sondern schlitzförmig, wobei sich die Öffnung 4' von dem Zentrum Z bis zum inneren Ringradius R_{I} erstreckt. Die Öffnung 4' kann im Allgemeinen jede beliebige Form annehmen, welche die beschriebenen Funktionalitäten ermöglicht. Die Öffnung 4' ist im Gegensatz zu den übrigen Bauteilen nicht rotationssymmetrisch zum Zentrum Z. Somit ergibt sich auch eine im Vergleich zur Ausführungsform gemäß Figuren 2a und 2b größere Auflagefläche 12'.

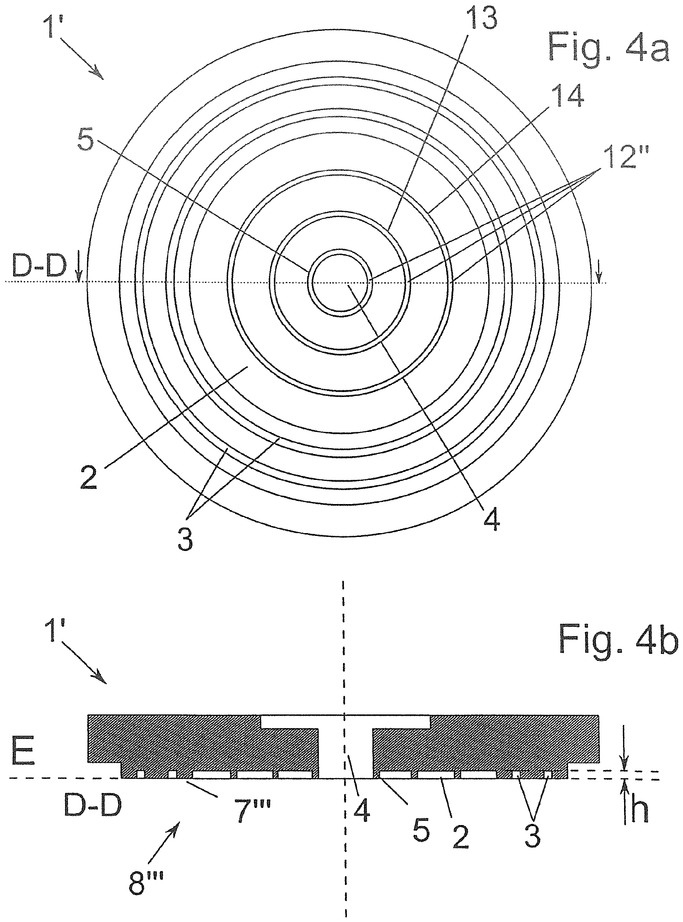

In der vierten Ausführungsform gemäß Figuren 4a und 4b sind zusätzlich zu dem Vorsprung 5 zwei weitere Vorsprünge 13, 14 vorgesehen, die zum ersten Vorsprung 5 konzentrisch im inneren Ringabschnitt 11, insbesondere äquidistant zueinander, verteilt angeordnet sind. Somit ist die Auflagefläche 12" beim vierten Ausführungsbeispiel nochmals größer als beim zweiten und dritten Ausführungsbeispiel, so dass sich eine in der Fläche gleichmäßiger verteilte Auflagefläche 12" ergibt.

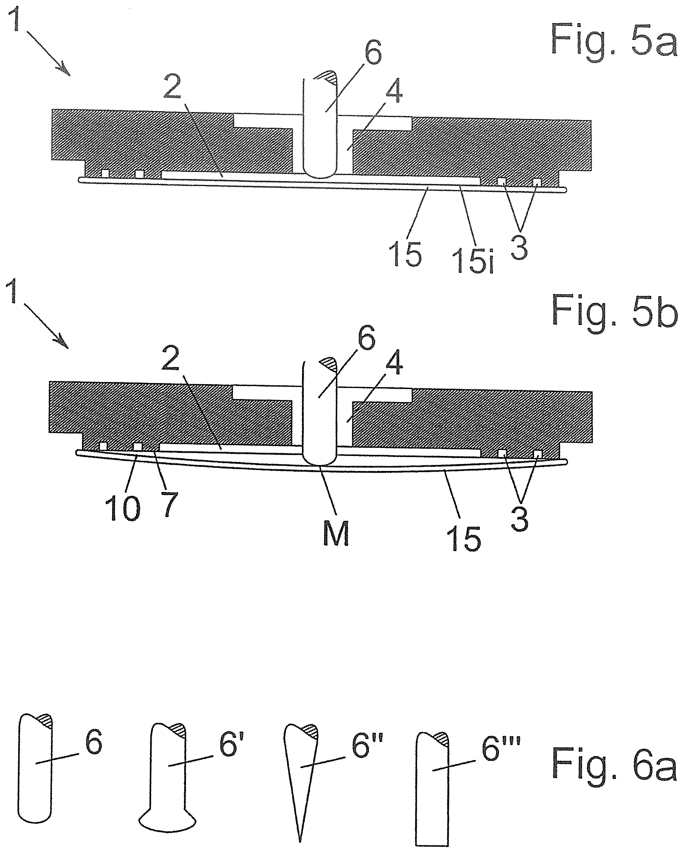

Bei allen Ausführungsbeispielen kann durch die Öffnung 4, 4' ein, insbesondere zur Innenkontur der Öffnung 4, 4' korrespondierender, Stift 6 (siehe Figuren 5a und 5b) geführt werden, um das Halbleitersubstrat 15 durch Beaufschlagung des Halbleitersubstrats 15 an seiner Innenfläche 15i mit der Aufnahmefläche 7, 7', 7", 7"' von dieser abzulösen. Der Stift 6 wird vorzugsweise berührungsfrei zur (Innenkontur der) Öffnung 4, 4' geführt. Die Vakuumbahnen 3 können kontinuierlich evakuiert und geflutet werden, mit Vorzug durch die Steuerungseinheit der Vorrichtung.

Statt des Stifts 6 ist eine Druckbeaufschlagung der Vertiefung 2 mit einem Fluid, insbesondere einem Gas, erfindungsgemäß denkbar, was eine gleichmäßige/homogene Druckverteilung an der Beaufschlagungsfläche innerhalb der Vertiefung 2 mit sich bringt.

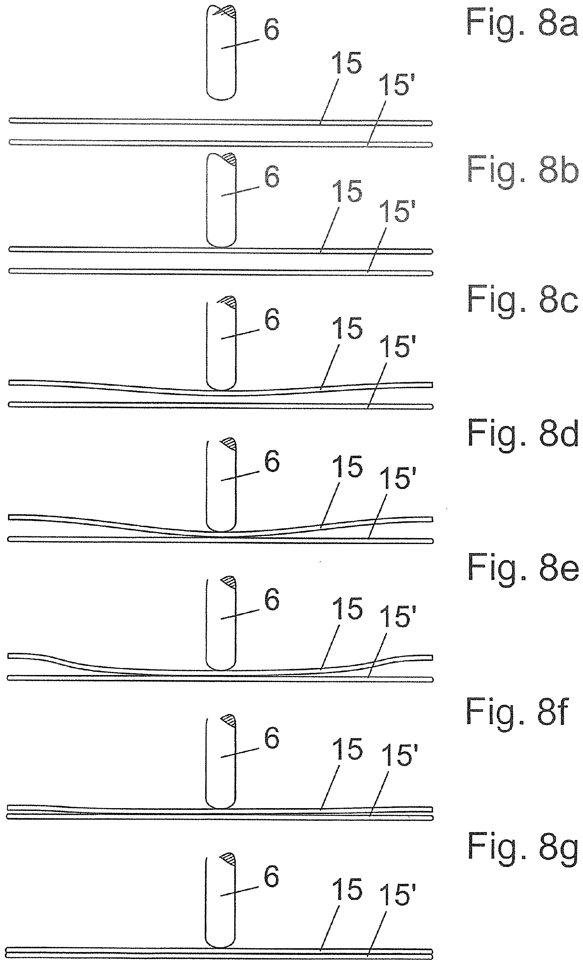

Die Verformung (Durchbiegung) des ersten Substrats 15 wird mit Vorzug kontrolliert gesteuert und ist mit Vorzug bis zum vollständigen Ablösen des Wafers 15 vom Probenhalter reversibel (Fig. 8a-g). Durch die Fixierung des ersten Substrats 15 im äußeren Ringabschnitt 12 ist eine Amplitude der Verformung begrenzt und erfindungsgemäß erfolgt nur eine geringfügige Verformung, insbesondere mit einer Amplitude weniger als die Höhe h.

Die in Fig. 5b gezeigte Verformung des ersten Substrats 15 dient erfindungsgemäß zur Kontaktierung eines gegenüberliegend angeordneten und zu dem ersten Substrat 15 vor Kontaktierung der Substrate ausgerichteten zweiten Substrats. Die Kontaktierung erfolgt durch die konzentrische Verformung des ersten Substrats 15 jeweils in der Mitte M der Substrate.

Während der Beaufschlagung der Innenfläche 15i und nach Kontaktierung der Substrate wird der Unterdruck an den Unterdruckkanälen 3, insbesondere geregelt, reduziert. Durch die mittels der Verformung des ersten Substrats 15 eingebrachte Vorspannung und/oder die wirkende Schwerkraft wird das erste Substrat 15 ausgehend von der Mitte M des ersten Substrats 15 radial nach außen bis zum Umfang des ersten Substrats 15 mit dem zweiten Substrat kontaktiert und zumindest temporär gebondet, wobei eine Bondwelle quasikonzentrisch von der Mitte M des ersten Substrats 15 bis zu dessen Umfang fortschreitet.

Beispiele für erfindungsgemäße Formen des Stifts 6, 6', 6", 6''' sind in der Fig. 6 gezeigt. Der Stift 6, 6', 6", 6"' kann erfindungsgemäß nicht nur an die Form beziehungsweise in die Kontur der Öffnung 4, 4' angepasst sein, sondern beispielsweise im Querschnitt T-förmig (Stift 6') ausgebildet sein, um das Halbleitersubstrat 15 mit einer größeren Fläche zu beaufschlagen und somit schonender zu behandeln. Als Kopf des Stifts 6' kann somit eine sich in der Vertiefung 2 über die Innenkontur der Öffnung 4 hinaus erstreckende Druckplatte vorgesehen sein. Weiterhin ist der Stift 6, 6', 6", 6"' gemäß einer vorteilhaften Ausführung federbeaufschlagt.

Eine Ringbreite b_{A} des äußeren Ringabschnitts 10 ist erfindungsgemäß kleiner als der innere Ringradius R_{I}, insbesondere kleiner als eine Ringbreite b_{I} des inneren Ringabschnitts 11 (siehe Figuren 1a, 1b).

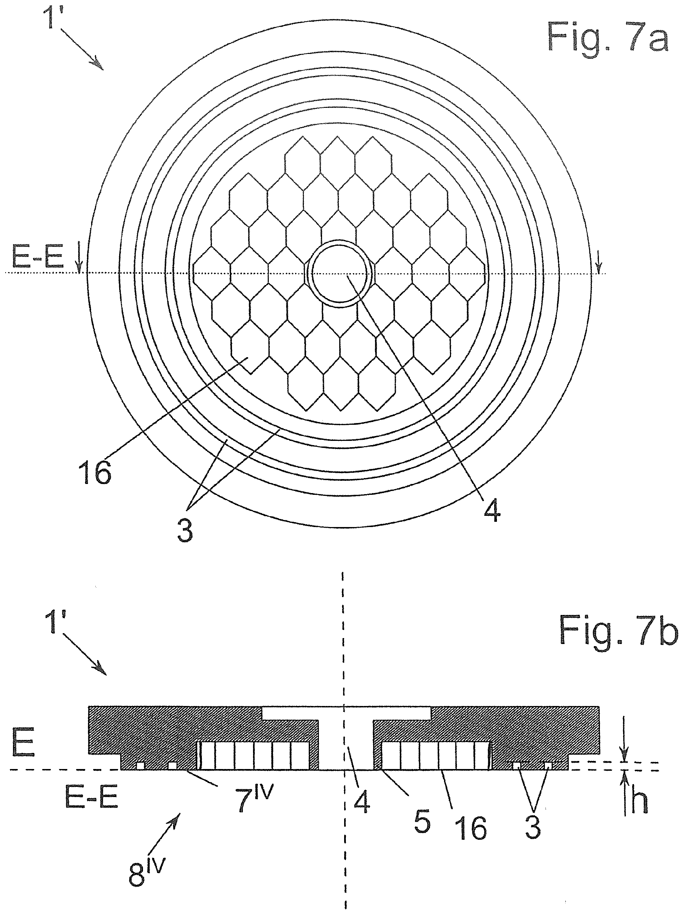

Eine weitere, mit den vorherigen Ausführungsformen kombinierbare Ausführungsform ist in den Figuren 7a, 7b gezeigt. Im Bereich der Vertiefung 2 sind, insbesondere wabenförmige, Fixierelemente 16 vorgesehen, mit welchen korrespondierende Fixierabschnitte des ersten Substrats 15 lokal an der Aufnahmeeinrichtung fixierbar sind, und zwar entgegen der Wirkungsrichtung der Beaufschlagung der Innenfläche 15i bei der Verformung des ersten Substrats 15. Die Ansteuerung der Fixierelemente 16 erfolgt durch die Steuerungseinrichtung. Somit kann gezielt auf die Verformung des ersten Substrats 15 in Richtung des zweiten Substrats Einfluss genommen werden. An Hand von Dehnungs-/Spannungskarten des zu bondenden ersten Substrats 15 ist somit ein gezieltes Reduzieren von Spannungen/Dehnungen des ersten Substrats 15 erfindungsgemäß möglich, so dass die gegebene Ausrichtungsgenauigkeit der Substrate zueinander (beziehungsweise etwaiger Strukturen/Elemente auf den Substraten) nicht durch vorhandene Spannungen/Dehnungen der Substrate oder zumindest des ersten Substrats 15 reduziert wird. Durch gezieltes Ansteuern einzelner Fixierelemente 16 ist eine Verformung (Scheren, Stauchen, Dehnen, Rotieren) der korrespondierenden Fixierabschnitte des ersten Substrats 15 möglich. Dies spielt bei den zu erreichenden Ausrichtungsgenauigkeiten von weniger als 250nm, insbesondere weniger als 150nm, vorzugsweise weniger als 100nm eine immer größere Rolle, da Verzerrungen/Dehnungen der Substrate lokale Ausrichtungsfehler von bis zu 100nm verursachen können.

Die Fixierelemente 16 sind insbesondere elektrostatisch aufladbar oder als Piezoelemente ausgebildet.

Es ergibt sich bei dieser Ausführungsform eine größere wirksame Aufnahmefläche 7^{IV} sowie eine gegenüber den vorher beschriebenen Ausführungsformen größere Aufnahmekontur 8^{IV}, so dass eine bessere Unterstützung des ersten Substrats 15 gegeben ist.

### Bezugszeichenliste

- 1: Aufnahmeeinrichtung
- 1k: Aufnahmekörper
- 2: Vertiefung
- 2b: Boden
- 3: Unterdruckkanal
- 4, 4': Öffnung
- 5, 5': Vorsprung
- 6: Stift
- 7, 7', 7", 7"', 7^{IV}: Aufnahmefläche
- 8, 8', 8", 8"', 8^{IV}: Aufnahmekontur
- 9: Absatz
- 10: äußerer Ringabschnitt
- 11: innerer Ringabschnitt
- 12, 12', 12": Auflagefläche
- 13: Vorsprung
- 14: Vorsprung
- 15: Erstes Substrat (Halbleitersubstrat)
- 15i: Innenfläche
- 16: Fixierelemente
- b_{A}: Ringbreite
- b_{I}: Ringbreite
- Rₖ: Radius
- R_{A}: äußerer Ringradius
- R_{I}: innerer Ringradius
- Z: Zentrum
- E: Aufnahmeebene
- M: Mitte

## Patentansprüche

1. Vorrichtung zum Bonden eines ersten Substrats (15) mit einem zweiten Substrat mit folgenden Merkmalen:
- einer Aufnahmeeinrichtung zur Aufnahme des ersten Substrats (15) an einer Aufnahmekontur (8, 8', 8", 8"', 8^{IV}) mit einer wirksamen Aufnahmefläche (7, 7', 7", 7"', 7^{IV}) der Aufnahmeeinrichtung mit einem äußeren Ringabschnitt (10) zur steuerbaren Fixierung des ersten Substrats (15),
- Verformungsmitteln zur steuerbaren Verformung des ersten Substrats (15), wobei die Verformungsmittel innerhalb des äußeren Ringabschnitts wirkend ausgebildet sind und
- Bondmitteln zum Bonden des ersten Substrats (15) mit dem zweiten Substrat (15'),
wobei eine Loslösung des ersten Substrats (5) von der Aufnahmefläche (7, 7', 7", 7"', 7^{IV}) derart kontrollierbar ist, dass das erste Substrat (5) von innen nach außen entfernbar ist.

2. Vorrichtung gemäß Anspruch 1, bei der die Aufnahmekontur (8, 8', 8", 8''', 8^{IV}) und/oder die Aufnahmefläche (7, 7', 7", 7"', 7^{IV}) und/oder die Aufnahmeeinrichtung rotationssymmetrisch, insbesondere konzentrisch zu einem Zentrum Z der Aufnahmeeinrichtung, ausgebildet ist/sind.

3. Vorrichtung nach einem der vorhergehenden Ansprüche, bei der mindestens ein die Aufnahmefläche (7, 7', 7", 7"', 7^{IV}) unterbrechender Unterdruckkanal (3) in dem äußeren Ringabschnitt (10) der Aufnahmekontur (8, 8', 8", 8"', 8^{IV}) vorgesehen ist und wobei die Aufnahmekontur (8, 8', 8", 8"', 8^{IV}) in einem inneren Ringabschnitt (11) zumindest überwiegend gegenüber der Aufnahmefläche (7, 7', 7", 7"', 7^{IV}) zurückgesetzt ist.

4. Vorrichtung nach einem der vorhergehenden Ansprüche, bei welcher der Unterdruckkanal (3) konzentrisch, insbesondere kreisringförmig, zu einem Zentrum Z der Aufnahmeeinrichtung, insbesondere vollumfänglich, verläuft.

5. Vorrichtung nach Anspruch 3 oder 4, bei der die Ringbreite b_{A} des äußeren, insbesondere kreisringförmigen, Ringabschnitts (10) kleiner als die Ringbreite b_{I} des inneren Ringabschnitts (11) ist.

6. Vorrichtung nach einem der vorhergehenden Ansprüche, bei der die Projektionsfläche der Aufnahmekontur (8, 8', 8", 8"') mindestens doppelt, insbesondere mindestens dreimal, so groß wie die wirksame Aufnahmefläche (7, 7', 7", 7"', 7^{IV}) ist.

7. Vorrichtung nach einem der vorhergehenden Ansprüche, bei der die Aufnahmekontur (8, 8', 8", 8"', 8^{IV}) im inneren Ringabschnitt (11) mindestens eine, insbesondere kreisringförmige, vorzugsweise konzentrisch zum Zentrum Z angeordnete, Auflagefläche (12, 12', 12") zur Auflage, insbesondere ohne aktive Fixierung, des Halbleitersubstrats (15) aufweist, wobei die Auflagefläche (12, 12', 12") zur Aufnahmefläche (7, 7', 7", 7"', 7^{IV}) zählt und mit dieser in einer Aufnahmeebene E fluchtet.

8. Vorrichtung nach einem der vorhergehenden Ansprüche, bei der die Verformungsmittel eine Beaufschlagung des Halbleitersubstrats (15) auf der Seite der Aufnahmefläche (7, 7', 7", 7"', 7^{IV}), insbesondere außerhalb, vorzugsweise ausschließlich außerhalb, der Aufnahmefläche (7, 7', 7", 7''', 7^{IV}) bewirkend ausgebildet sind.

9. Vorrichtung nach einem der vorhergehenden Ansprüche, bei der als Verformungsmittel mindestens ein die Aufnahmekontur (8, 8', 8", 8''', 8^{IV}) durchsetzendes Druckelement (6, 6', 6", 6'") vorgesehen ist.

10. Vorrichtung nach einem der vorhergehenden Ansprüche, bei der die Verformungsmittel derart ausgebildet sind, dass die Verformung konzentrisch zum ersten Substrat (15) erfolgt.

11. Vorrichtung nach Anspruch 2, bei der im inneren Ringabschnitt (11), insbesondere einzeln ansteuerbare, Fixierelemente (16) zur Fixierung von korrespondierenden Fixierabschnitten entlang des ersten Substrats (15) vorgesehen sind.

12. Verfahren zum Bonden eines ersten Substrats (15) mit einem zweiten Substrat mit folgenden Schritten, insbesondere folgendem Ablauf:
- Aufnahme des ersten Substrats (15) an einer Aufnahmekontur (8, 8', 8", 8"') mit einer wirksamen Aufnahmefläche (7, 7', 7", 7"', 7^{IV}) der Aufnahmeeinrichtung (1) mit einem äußeren Ringabschnitt (10) zur steuerbaren Fixierung des ersten Substrats (15),
- Verformung des ersten Substrats (15) innerhalb des äußeren Ringabschnitts durch Verformungsmitteln zur steuerbaren Verformung des ersten Substrats (15)
- Bonden des ersten Substrats (15) mit dem zweiten Substrat durch Bondmittel,
wobei eine Loslösung des ersten Substrats (5) von der Aufnahmefläche (7, 7', 7", 7"', 7^{IV}) derart kontrolliert wird, dass das erste Substrat (5) von innen nach außen entfernt wird.

13. Verfahren nach Anspruch 12, bei dem das Bonden durch die Verformung des ersten Substrats (15) im Wesentlichen konzentrisch von einer Mitte M der Kontaktfläche des ersten und zweiten Substrats (15,) ausgehend erfolgt.

14. Verfahren nach einem der Ansprüche 12 oder 13, bei dem, insbesondere durch ein vorgeschaltetes Messverfahren ermittelte, Verzerrungen und/oder Dehnungen des ersten und/oder zweiten Substrats durch Einwirkung, insbesondere durch gesteuerte Verzerrung und/oder Dehnung von Abschnitten des ersten und/oder zweiten Substrats, auf das erste und/oder zweite Substrat reduziert werden, insbesondere mittels Fixierelementen (16) zur Fixierung von korrespondierenden Fixierabschnitten.
